(19) Europäisches Patentamt
European Patent Office
Office européen des brevets

(11) EP 1 640 423 B1

(12) **EUROPEAN PATENT SPECIFICATION**

(45) Date of publication and mention of the grant of the patent:
**06.11.2013 Bulletin 2013/45**

(21) Application number: **04722971.1**

(22) Date of filing: **24.03.2004**

(51) Int Cl.:
***C09D 183/16*** *(2006.01)* ***C01B 33/12*** *(2006.01)*
***H01L 21/768*** *(2006.01)*

(86) International application number:
**PCT/JP2004/004078**

(87) International publication number:
**WO 2004/096934 (11.11.2004 Gazette 2004/46)**

(54) **COATING COMPOSITION, POROUS SILICEOUS FILM, METHOD FOR PREPARING POROUS SILICEOUS FILM, AND SEMICONDUCTOR DEVICE**

BESCHICHTUNGSZUSAMMENSETZUNG, PORÖSER SILIZIUMDIOXIDHALTIGER FILM, VERFAHREN ZUR HERSTELLUNG EINES PORÖSEN SILIZIUMDIOXIDHALTIGEN FILMS SOWIE HALBLEITERVORRICHTUNG

COMPOSITION DE REVETEMENT, FILM SILICEUX POREUX, PROCEDE DE PREPARATION DUDIT FILM SILICEUX POREUX ET DISPOSITIF A SEMI-CONDUCTEUR

(84) Designated Contracting States:
**AT BE BG CH CY CZ DE DK EE ES FI FR GB GR HU IE IT LI LU MC NL PL PT RO SE SI SK TR**

(30) Priority: **01.05.2003 JP 2003126381**

(43) Date of publication of application:
**29.03.2006 Bulletin 2006/13**

(73) Proprietor: **AZ Electronic Materials USA Corp.**
**Somerville, NJ 08876 (US)**

(72) Inventors:
- **AOKI, Tomoko**
**Bunkyo-ku,**
**Tokyo 113-0021 (JP)**
- **AOKI, Hiroyuki**
**Bunkyo-ku,**
**Tokyo 113-0021 (JP)**

(74) Representative: **Isenbruck, Günter et al**
**Isenbruck Bösl Hörschler LLP**
**Eastsite One**
**Seckenheimer Landstrasse 4**
**68163 Mannheim (DE)**

(56) References cited:
**WO-A1-01/04049** **WO-A1-02/19410**
**JP-A- 7 292 321** **JP-A- 7 305 029**
**JP-A- 10 218 690**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 640 423 B1

## Description

TECHNICAL FIELD

The present invention relates to a porous siliceous film having low permittivity, a semiconductor device comprising said porous siliceous film, and a coating composition for providing said porous siliceous film.

BACKGROUND ART

For electronic materials such as interlayer insulation films for semiconductors, increased speed of integrated circuits and increased integration density have led to a demand for further lowered permittivity, and it is known that rendering the film porous is effective for lowering the specific permittivity of the siliceous film. The siliceous film is generally hygroscopic, and, under ambient environment, disadvantageously, the specific permittivity increases with the elapse of time.

Another method in which an organic siliceous film prepared by firing an organic polysilazane to give an organic siliceous film and rendering the organic siliceous film porous is considered effective for preventing the increase in specific permittivity with the elapse of time. In this method, by virtue of the structure in which an organic group is attached directly to the silicon atom of silica, the film per se has a high level of water repellency and, thus, an increase in specific permittivity by hygroscopic properties with the elapse of time can be suppressed and, at the same time, a porous film having heat resistance and environmental resistance required of the interlayer insulation film for semiconductors can be realized.

A further increase in integration density of integrated circuits has also led to a demand for the development of a multilayer interconnection process technique that can more efficiently realize an increase in the level of fineness and multilayer interconnection in semiconductor devices. The multilayer interconnection process is typified by a damascene process that comprises previously forming predetermined grooves in an interlayer insulation film, filling a wiring material such as Cu (copper) into the grooves by a sputter reflow method or CVD and removing the wiring material deposited outside the grooves, for example, by CMP (chemical mechanical polishing) to form groove wiring. The advance of the groove wiring technique can realize a higher level of fineness of internal wiring in semiconductor devices and, at the same time, a higher level of multilayer interconnection through surface flattening by CMP.

For increased integration density of the integrated circuit, the interlayer insulation film present between wirings should have further lowered permittivity and, in addition, should have mechanical strength high enough to withstand the step of removing the wiring material by CMP. Further, the interlayer insulation film should have resistance to various chemicals, for example, not only chemicals used in CMP but also chemicals used in the step of removing a photoresist by wet stripping, and chemicals for removing the residue after ashing in the removal of the photoresist by ashing.

In order to meet the above demand, Japanese Patent Laid-Open No. 75982/2002 proposes a high-strength porous siliceous film prepared by firing a film of a composition comprising a polyalkylsilazane and a polyacrylic ester or a polymethacrylic ester. Certainly, this porous siliceous film has the effect of suppressing the increase in specific permittivity caused by moisture absorption with the elapse of time, but on the other hand, in this porous film, the modulus of elasticity is still limited to not more than 3 GPa (in the case where the specific permittivity is around 2.2). Therefore, a further improvement in film strength has been desired.

JP-A 07-292 321 and JP-A 07-305029 disclose a coating composition for producing a ceramic coating consisting of a polysilazane and an acrylic resin. The compositions comprise an organic solution of a polysilazane which is preferably a perhydropolysilazane. Neither document discloses the combination of a polyalkylsilazane and an acrylic resin comprising side groups with COOH and/or OH groups.

WO 02/19410 discloses a solution of a a polyalkylsilazane and a polyacrylic or polymethacrylic ester, which is used to produce a coating on a substitute which is then further converted to a siliceous film. According to example 3 of this document, the respective films have a low permittivity and an elastic modulus below 2.5 GPa.

Accordingly, an object of the present invention is to provide a coating composition and a porous siliceous film useful for an interlayer insulation film that has mechanical strength high enough to withstand an advanced high integration process including a damascene process, stably exhibits a very low level of specific permittivity (particularly less than 2.5) and, at the same time, has resistance to various chemicals.

DISCLOSURE OF THE INVENTION

The present inventors have made extensive and intensive studies with a view to solving the above problems of the prior art and, as a result, could regulate the size of micropores which greatly affect the mechanical strength in the porous thin film. This has led to the completion of the present invention. That is, the present invention is defined by the following matters.

[1] A coating composition characterized by comprising:

an organic solvent and, contained in said organic solvent,

1) a polyalkylsilazane and
2) at least one organic resin component selected from the group consisting of homopolymers and copolymers of acrylic esters and methacrylic esters,

group -COOH and/or group -OH being contained in at least a part of side groups contained in at least one type of the organic resin component, characterized in that said group -COOH and/or group -OH are contained in an amount of 0.01 to 50% by mole based on the total number of monomers of said organic resin component.

[2] The coating composition according to the above item [1], characterized in that said organic resin component has a number average molecular weight of 1,000 to 800,000.
[3] The coating composition according to the above item [1] or [2], characterized in that said organic resin component is contained in an amount of 5 to 150% by mass based on said polyalkylsilazane.
[4] The coating composition according to any one of the above items [1] to [3], characterized in that said polyalkylsilazane comprises repeating units represented by
formula (1) and at least one type of units represented by
formula (2) or formula (3) and has a number average molecular weight of 100 to 50,000:

$$-(SiR^1(NR^2)_{1.5})- \quad (1)$$

wherein $R^1$ and $R^2$ each independently represent a hydrogen atom or an alkyl group having 1 to 3 carbon atoms, excluding the case where $R^1$ and $R^2$ simultaneously represent a hydrogen atom;

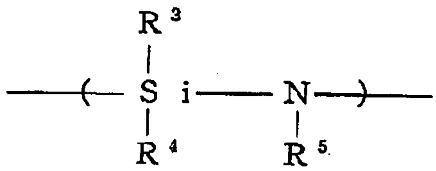

(2)

wherein $R^3$, $R^4$ and $R^5$ each independently represent a hydrogen atom or an alkyl group having 1 to 3 carbon atoms, excluding the case where $R^3$ and $R^4$ simultaneously represent a hydrogen atom;

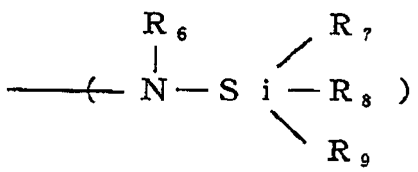

(3)

wherein $R^6$ to $R^9$ each independently represent a hydrogen atom or an alkyl group having 1 to 3 carbon atoms, excluding the case where all of $R^6$, $R^7$, and $R^8$ simultaneously represent a hydrogen atom.
[5] The coating composition according to the above item [4], characterized in that, in formula (1), $R^1$ represents a methyl group and $R^2$ represents a hydrogen atom; in formula (2), $R^3$ and $R^4$ represent a hydrogen atom or a methyl group and $R^5$ represents a hydrogen atom; and, in formula (3), $R^7$, $R^8$ and $R^9$ represent a methyl group and $R^6$ represents a hydrogen atom.
[6] The coating composition according to the above item [4] or [5], characterized in that said polyalkylsilazane comprises not less than 50%, based on the total number of units represented by formulae (1), (2) and (3), of repeating units represented by formula (1).
[7] The coating composition according to the above item [6], characterized in that said polyalkylsilazane comprises not less than 80%, based on the total number of units represented by formulae (1), (2) and (3), of repeating units represented by formula (1).
[8] A porous siliceous film characterized by being produced by firing a film of a coating composition according to any one of the above items [1] to [7], said porous siliceous film having a specific permittivity of less than 2.5, and a modulus of elasticity of not less than 3GPa.

[9] A process for producing a porous siliceous film characterized by comprising coating a coating composition on a substrate according to any one of the above items [1] to [7] to form a film which is prefired in a water vapor-containing atmosphere at a temperature of 50 to 300°C and is then fired in a dry atmosphere at a temperature of 300 to 500°C.

[10] The process for producing a porous siliceous film according to the above item [9], characterized in that the prefired film is allowed to stand in the atmosphere or is subjected to moisture absorption under a humidified atmosphere followed by firing.

[11] A semiconductor device characterized by comprising a porous siliceous film according to the above item [8] as an interlayer insulation film.

When the proportion of the difference between "density of a film free from micropores" and "density of a film having the same matrix (substrate) composition and having micropores" is defined as "void content," in principle, a porous film having the same void content as the matrix composition has the same specific permittivity. In this connection, it is generally known that the mechanical strength increases with reducing the size of the pores and increasing the uniformity of the size of the pores.

One of methods for reducing the size of pores is to very finely disperse a matrix material (for example, a heat curable resin component) of the film and a volatile component (for example, a thermoplastic organic resin component) for forming pores upon firing. Full compatibilization of these components is disadvantageous in that, in some cases, pores are not formed during firing, or, even when the pores are successfully formed, the effect of lowering the permittivity cannot be attained. Therefore, in volatilizing the resin component, this should undergo phase separation to some extent. Significant phase separation, however, of course results in increased diameter of the formed pores.

Although the composition comprising a polyalkylsilazane and a polyacrylic ester or a polymethacrylic ester proposed in Japanese Patent Laid-Open No. 75982/2002 has very good compatibility, there is a possibility that relatively macroscopic phase separation takes place under some firing conditions.

According to the invention of the present application, a specific organic resin component is attached to the polyalkylsilazane in the substrate through its crosslinking forming group to impose given restrictions on the separation of the organic resin component, whereby a composition which does not cause macroscopic phase separation is provided.

## BEST MODE FOR CARRYING OUT THE INVENTION

The coating composition according to the present invention is characterized by comprising:

an organic solvent and, contained in said organic solvent,

1) a polyalkylsilazane and
2) at least one organic resin component selected from the group consisting of homopolymers and copolymers of acrylic esters and methacrylic esters,

group -COOH and/or group -OH being contained in at least a part of side groups contained in at least one type of the organic resin component, characterized in that said group -COOH and/or group -OH are contained in an amount of 0.01 to 50% by mole based on the total number of monomers of said organic resin component.

Preferably, the polyalkylsilazane comprises, in its molecular chain, repeating units represented by formula (1) and at least one type of units represented by formula (2) or formula (3) or comprises all the above units and has a number average molecular weight of 100 to 50,000:

$$-(SiR^1(NR^2)_{1.5})- \qquad (1)$$

wherein $R^1$ and $R^2$ each independently represent a hydrogen atom or an alkyl group having 1 to 3 carbon atoms, excluding the case where $R^1$ and $R^2$ simultaneously represent a hydrogen atom;

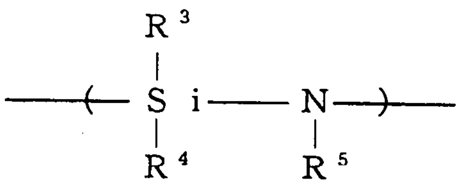

(2)

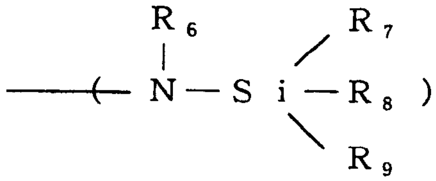

(3)

wherein $R^3$, $R^4$ and $R^5$ each independently represent a hydrogen atom or an alkyl group having 1 to 3 carbon atoms, excluding the case where $R^3$ and $R^4$ simultaneously represent a hydrogen atom; and $R^6$ to $R^9$ each independently represent a hydrogen atom or an alkyl group having 1 to 3 carbon atoms, excluding the case where all of $R^6$, $R^7$, and $R^8$ simultaneously represent a hydrogen atom. Methyl, ethyl, and propyl groups may be mentioned as the alkyl group. The methyl group is a particularly preferred alkyl group. A polyalkylsilazane containing an alkyl group having 4 or more carbon atoms is unfavorable because the resultant porous film is excessively soft. The polyalkylsilazane defined by formula (2) is particularly preferably such that $R^3$ and $R^4$ represent a hydrogen atom or a methyl group, excluding the case where $R^1$ and $R^2$ simultaneously represent a hydrogen atom; and $R^5$ represents a hydrogen atom. The polyalkylsilazane defined by formula (3) is particularly preferably such that $R^7$, $R^8$ and $R^9$ represent a methyl group and $R^6$ represents a hydrogen atom.

The polyalkylsilazane which is particularly preferred in the present invention comprises, in its molecular chain, repeating units represented by formula (1) and has a number average molecular weight of 100 to 50,000. The reason for this is that, when the number average molecular weight is not more than 100, disadvantageously, the thin film is not formed (this is particularly significant when the coating is carried out by spin coating), while, when the number average molecular weight exceeds 50000, the number of crosslinking groups is so large that gelation takes place.

In the present invention, a polyalkylsilazane comprising repeating units represented by formula (1) and either formula (2) or (3), or repeating units represented by formula (1) and both formulae (2) and (3) is particularly useful because gelation during storage of the composition can be prevented. In this case, not less than 50%, preferably not less than 80%, more preferably not less than 90%, of the total number of units represented by formula (1) and either formula (2) or (3), or the total number of units represented by formula (1) and formulae (2) and (3) is accounted for by the number of repeating units represented by formula (1). This is because, when the proportion is not more than 50%, unfavorable phenomena such as repelling or uneven coating are likely to occur during film formation.

These polyalkylsilazanes may be produced by using, in ammonolysis used in the synthesis of the conventional polysilazane which is self-evident to a person having ordinary skill in the art, as a starting material, an alkyltrichlorosilane ($R^1SiCl_3$) in the case of a polyalkylsilazane comprising repeating units represented by formula (1); a dialkyldichlorosilane ($R^3R^4SiCl_2$) in the case of a polyalkylsilazane comprising repeating units represented by formula (2); a trialkylchlorosilane ($R^6R^7R^8SiCl$) in the case of a polyalkylsilazane comprising units represented by formula (3); or a mixture of the above chlorosilanes in the case of a polyalkylsilazane comprising both the above repeating units. The proportions of the individual units in the polyalkylsilazane are determined by the mixing ratio of these chlorosilanes.

Preferably, the polyalkylsilazane according to the present invention is dissolved in an active hydrogen-free inert organic solvent before use. Such organic solvents include: aromatic hydrocarbon solvents such as benzene, toluene, xylene, ethylbenzene, diethylbenzene, trimethylbenzene, and triethylbenzene; alicyclic hydrocarbon solvents such as cyclohexane, cyclohexene, decahydronaphthalene, ethylcyclohexane, methylcyclohexane, p-menthine, and dipentene (limonene); ether solvents such as dipropyl ether and dibutyl ether; ketone solvents such as methyl isobutyl ketone; and ester solvents such as propylene glycol monomethyl ether acetate.

The coating composition according to the present invention may be prepared by adding, to an organic solvent solution containing the above polyalkylsilazane, at least one organic resin component selected from the group consisting of homo- and copolymers of acrylic esters and methacrylic esters, group -COOH and/or group -OH being contained in at least a part of side groups contained in at least one type of the organic resin component.

Homo- and copolymers of acrylic esters and methacrylic esters according to the present invention include any combination of homopolymers of acrylic esters, for example, polymethyl acrylate and polyethyl acrylate; homopolymers of methacrylic esters, for example, polymethyl methacrylate and polyethyl methacrylate; copolymers of acrylic esters, for example, poly(methyl acrylate-co-ethyl acrylate); copolymers of methacrylic esters, for example, poly(methyl methacrylate-co-ethyl methacrylate); and copolymers of acrylic esters with methacrylic esters, for example, poly(methyl acrylate-co-ethyl metharylate).

When the organic resin component is a copolymer, the sequence of monomers is not limited, and random copolymers, block copolymers and copolymers of other desired monomer sequence may be used.

Monomers constituting homo- and copolymers of acrylic esters and methacrylic esters include, but are not limited to, methyl methacrylate, ethyl methacrylate, n-butyl methacrylate, i-butyl methacrylate, t-butyl methacrylate, methyl acrylate, ethyl acrylate, n-butyl acrylate, i-butyl acrylate, and t-butyl acrylate. In particular, a combination of methyl methacrylate with n-butyl methacrylate and a combination of n-butyl acrylate with i-butyl acrylate are more

preferred from the viewpoint of compatibility with polyacrylsilazane.

According to the present invention, group -COOH and/or group -OH are contained in at least a part of side groups contained in at least one type of the organic resin component. Group -COOH and/or group -OH may be previously contained in monomers for constituting the organic resin component. Monomers containing group -COOH or group -OH include, but are not limited to, acrylic acid, methacrylic acid, 2-hydroxyethyl methacrylate, 2-hydroxypropyl methacrylate, and 2-hydroxybutyl methacrylate. In particular, acrylic acid, methacrylic acid, 2-hydroxyethyl methacrylate are preferred from the viewpoint of easiness on a reaction with polyacrylsilazane.

Alternatively, group -COOH and/or group -OH may be introduced into side chains of homopolymers or copolymers later. For example, group -COOH may be introduced into side chains by at least partially hydrolyzing a polymethacrylic ester.

When two or more organic resin components are present, the presence of group -COOH and/or group -OH in at least one type of the organic resin components suffices for contemplated results. Accordingly, a mixture of an organic resin containing neither group -COOH nor group -OH, for example, a polyacrylic ester, with an organic resin containing group -COOH and/or group -OH, for example, poly(methacrylic ester-co-methacrylic acid), may be used as the organic resin component.

In the present invention, crotonic acid and isocrotonic acid, i.e., structural isomers of methacrylic acid, are recognized as equivalents of methacrylic acid. Therefore, embodiments in which crotonic acid and isocrotonic acid corresponding to the above methacrylic acid and its ester and their esters are used also fall within the scope of the present invention.

The amount of the organic resin component added in the present invention is 5 to 150 % by mass based on the polyalkylsilazane used. When the amount of the organic resin component added is less than 5% by mass, the pore formation in the film is unsatisfactory, while, when the addition amount exceeds 150% by mass, defects such as voids or cracks occur in the film, resulting in lowered film strength. Therefore, both the above cases are unfavorable. The amount of the organic resin component added in the present invention is preferably 10 to 120% by mass, and, in particular, the addition of the organic resin component in an amount of 20 to 100% by mass provides optimal results.

In the present invention, the content of group -COOH and/or group -OH in the coating composition is 0.01 to 50 mol%, preferably 0.1 to 30 mol%, based on the total number of monomers constituting the organic resin component.

The unit containing group -COOH or group -OH contained in the above mixture or polymer, together with the polyalkylsilazane chain, forms a crosslinking bond through the group -COOH or group -OH. Therefore, the composition containing these units and the polyalkylsilazne as the substrate constitute a reaction product having a bond rather than a mere mixture. In this case, when the amount of group -COOH and/or group -OH exceeds 50% by mole, crosslinking with the polyalkylsilazane excessively proceeds and, thus, gelation easily occurs. On the other hand, when the amount of group -COOH and/or group -OH is less than 0.01% by mole, the degree of crosslinking is excessively low and any effect contemplated in the present invention cannot be attained.

The organic resin component in the present invention has a number average molecular weight of 1,000 to 800,000. When the number average molecular weight is less than 1,000, the organic resin component is sublimated at a very low temperature during the formation of a fired film and, consequently, no porous film is formed. On the other hand, when the number average molecular weight exceeds 800,000, the pore diameter is increased and this increase in pore diameter is causative of voids, leading to lowered film strength. Therefore, both the above cases are unfavorable. The molecular weight of the organic resin component in the present invention is preferably in the range of 1,000 to 600,000, and, in particular, a molecular weight of 10,000 to 200,000 provides the optimal results.

Thus, the organic resin component containing group -COOH and/or group -OH is attached to the polyalkylsilazane in the substrate through the group -COOH and/or group -OH to restrict the separation of the organic resin component, and, as a result, a composition free from macro phase separation (that is, the phase separation stays on the level of micro phase separation) can be provided.

In mixing the organic resin component in the present invention, in general, a method may be adopted in which the organic resin component is dissolved in an organic solvent to prepare a solution, the solution is added to a polyalkylsilazane solution, and the mixture is stirred. In this case, the same organic solvent as used in the preparation of the polyalkylsilazane solution may be used. Specifically, the above active hydrogen-free inert organic solvent may be used as the organic solvent for dissolution.

In the dissolution in this organic solvent, the concentration of the organic resin component in the present invention may be brought to a range of 5 to 80% by mass, preferably 10 to 40% by mass.

After the addition thereof, the mixture may be physically stirred for 1 to 24 hr to give a homogeneous reaction solution in which a crosslinking bond has been formed. Further, ultrasonic dispersion treatment on a hot-water bath of 30 to 80°C for about 5 to 90 min is more advantageous from the viewpoint of accelerating the reaction.

In this connection, it should be noted that the organic resin component in the present invention as such may also be added to, dissolved in and reacted with the polyalkylsilazane solution.

The composition as the reaction product thus obtained may be used, either as such or after concentration

regulation, as a coating composition for coating onto the surface of a base. The coating composition may be coated onto the surface of the base by conventional methods, for example, spin coating, dip coating, spray coating, or transfer.

The coating film formed on the surface of the base may be fired in various atmospheres. Atmospheres usable in this case include substantially water vapor-free atmospheres such as dry air, dry nitrogen, and dry helium, and water vapor-containing atmospheres such as air, humidified air, and humidified nitrogen. The firing temperature is 50 to 600°C, preferably 300 to 500°C, and the firing time is 1 min to 1 hr.

A preferred process for advantageously producing a siliceous film having low permittivity and good quality according to the present invention comprises forming the coating film on the surface of a base, then preheating the film in a water vapor-containing atmosphere, then allowing the assembly to stand in a humidified atmosphere for a short period of time (for example, 3 to 30 min) or in the air for a long period of time (for example, 24 hr), and then heat firing the assembly in a dry atmosphere. In this case, the content of water vapor in the water vapor-containing atmosphere is not less than 0.1% by volume, preferably not less than 1% by volume. Such atmospheres include the air, humidified air and humidified nitrogen gas. On the other hand, the content of water vapor in the dry atmosphere is not more than 0.5% by volume, preferably not more than 0.05% by volume. Dry atmospheres include dry air, nitrogen gas, argon gas, and helium gas. The preheating temperature is 50 to 300°C. On the other hand, the firing temperature is 100 to 500°C, preferably 300 to 500°C.

In the above step of firing, among SiH, SiR (R: hydrocarbon group) and SiN bonds in the polyalkylsilazane, only the SiN bond is oxidized and is consequently converted to SiO bond, whereby a siliceous film containing SiH and SiR bonds remaining unoxidized is formed. Thus, SiO bond formed by selective oxidation of SiN bond and the unoxidized SiH and SiR bonds can be allowed to exist in the formed siliceous film, whereby a low-density siliceous film can be provided. In general, the permittivity of the siliceous film lowers with lowering the density of the film. On the other hand, when the density of the film is lowered, the adsorption of water as a highly dielectric substrate occurs and thus poses a problem that, when the siliceous film is allowed to stand in the air, the permittivity of the film is increased. On the other hand, in the case of the siliceous film according to the present invention containing SiH or SiR bond, since these bonds are water repellent, the adsorption of water can be prevented despite the low density of the film. Therefore, the siliceous film according to the present invention has a great advantage that, even when the siliceous film is allowed to stand in the water vapor-containing air, the permittivity of the film is not substantially increased. Further, the siliceous film according to the present invention has low density and thus is advantageous in that the internal stress of the film is small and cracking is less likely to occur.

In the firing of the coating, micropores mainly having a diameter of 0.5 to 3 nm are formed within the siliceous film as a result of sublimation of the organic resin component in the coating film. By virtue of the presence of the pores, the density of the siliceous film is further lowered and, consequently, the specific permittivity of the siliceous film is further lowered. One of the reasons why such micropores are formed is believed to reside in that, in addition to very good compatibility with the organic resin component in the present invention, since a crosslinking bond is present between the polyalkylsilazane and the organic resin component containing group -COOH and/or group -OH, macrophase separation does not occur until the time immediately before the sublimation of the organic resin component.

The porous siliceous film according to the present invention can form very fine pores and thus has excellent mechanical strength. Specifically, the porous siliceous film according to the present invention has significantly high mechanical strength when the fact that the material is porous is taken into consideration, that is, has a mechanical strength of not less than 3 GPa and in some cases not less than 5 GPa in terms of modulus of elasticity as measured by a nanoindentation method which will be described later.

Accordingly, the porous siliceous film according to the present invention has both mechanical strength high enough to withstand the step of removing the wiring material by CMP and resistance to various chemicals and thus can be used as an interlayer insulation film suitable for advanced high integration processes including a damascene process. Further, the resistance to various chemicals is on a high level of not more than 1.0 angstrom/min, preferably not more than 0.8 angstrom/min, in terms of etching rate as measured, for example, with an etching residue peeling liquid which will be described later.

Further, in the siliceous film according to the present invention, the water repellent group in the polyalkylsilazane as the matrix component remains unremoved after firing in a satisfactory amount and, hence, when it is allowed to stand in the water vapor-containing air, the specific permittivity which has been lowered due to the presence of the pores is not substantially increased. Thus, according to the present invention, a porous siliceous film can be provided in which, by virtue of lowered density and water repellency derived from bonding components (SiH, SiR) of the siliceous film and lowered density of the whole film derived from the pores in cooperation with each other, a very low level of specific permittivity of less than 2.5, preferably not more than 2.0, and in some cases about 1.6 can be stably maintained.

Regarding other properties of the porous siliceous film according to the present invention, the density is 0.5 to 1.6 g/$cm^3$, preferably 0.8 to 1.4 g/$cm^3$, and the crack limit film thickness is not less than 1.0 $\mu$m, preferably not less than 5$\mu$m, and the internal stress is not more than 80 MPa, preferably not more than 50 MPa. The content of Si present as SiH or SiR (R: hydrocarbon group) bond contained in the siliceous film is 10 to 100 atomic%, preferably 25 to 75 atomic%,

based on the number of Si atoms contained in the film. The content of Si present as SiN bond is not more than 5 atomic%. The thickness of the porous siliceous film obtained after firing may vary depending upon applications of the surface of the base. In general, however, the thickness of the porous siliceous film is 0.01 to 5 μm, preferably 0.1 to 2 μm. In particular, when the porous siliceous film is used as an interlayer insulation film for semiconductors, the thickness is 0.1 to 2 μm.

As described above, the porous siliceous film according to the present invention has low density and is also advantageous in that the crack limit film thickness, that is, the maximum film thickness which can form a film without cracking is as high as not less than 5 μm. In the conventional siliceous film, the crack limit film thickness is about 0.5 to 1.5 μm. Accordingly, the siliceous film according to the present invention has a great technical advantage over the conventional siliceous film.

The present invention provides for the first time a porous siliceous film that has a good balance between stable low permittivity, and mechanical strength high enough to withstand advanced fine wiring processes and resistance to various chemicals. The use of the porous siliceous film according to the present invention as an interlayer insulation film for semiconductor devices can realize a higher level of integration and a multi-level interconnection of integrated circuits. In addition to applications as interlayer insulation films, the coating composition according to the present invention can be of cause used to form a siliceous film on a solid surface of various materials such as metals, ceramics, wood and the like. The present invention can provide a metal substrate (for example, silicon, SUS, tungsten, iron, copper, zinc, brass, or aluminum) having a siliceous film on its surface and a ceramic substrate (for example, silica, a metal oxide such as alumina, magnesium oxide, titanium oxide, zinc oxide, or tantalum oxide, and, further, silicon nitride, boron nitride, a metal nitride such as titanium nitride, or silicon carbide) having a siliceous film on its surface.

EXAMPLES

The following Examples further illustrate the present invention. In the following Examples, the physical properties of siliceous films were evaluated by the following methods.

(Specific permittivity) A Pyrex (registered trademark) glass plate manufactured by Corning Inc. (thickness 1 mm, size 50 mm x 50 mm) was well cleaned with a neutral detergent, a dilute aqueous NaOH solution, and a dilute aqueous $H_2SO_4$ solution in that order and was then dried. An Al film was formed on the whole area of this glass plate by vacuum vapor deposition (0.2 μm). The composition solution was spin coated onto this glass plate to form a film, and the four corners of the glass plate were then rubbed with a swab to remove the polyalkylsilazane film (about 3 mm x 3 mm) for acquisition of electrode signals. Subsequently, this was converted to a siliceous film by the method according to Examples or Comparative Examples. An SUS mask was covered on the siliceous film thus formed, and an Al film was formed thereon by vacuum vapor deposition (18 patterns having a size of 2 mm x 2 mm square and a thickness of 2 μ). The capacitance was measured with a 4192 ALF Impedance Analyzer, manufactured by YHP (100 kHz). The layer thickness was measured with Spectroscopic Ellipsometer (M-44, manufactured by J.A. Woollam). The specific permittivity was calculated by the following equation.

$$\text{Specific permittivity} = (\text{capacitance [pF]}) \times (\text{layer thickness } [\mu m])/35.4$$

The value of the specific permittivity was a 18-point average value.

(Film density) The weight of a silicon wafer having a diameter of 4 in. (10.16 cm) and a thickness of 0.5 mm was measured with an electrobalance. The composition solution was spin coated onto the silicon wafer to form a film which was then converted to a siliceous film by the method according to Examples or Comparative Examples. The weight of the silicon wafer with the film was then measured with an electrobalance. The difference in weight between the measured weight of the wafer and the measured weight of the wafer with the film was regarded as the weight of the film. The film thickness was measured with Spectroscopic Ellipsometer (M-44, manufactured by J.A. Woollam), the same device as used in the evaluation of the specific permittivity. The film density was calculated by the following equation.

$$\text{Film density } [g/cm^3] = (\text{film weight [g]})/(\text{film thickness } [\mu m])/0.008$$

(Internal stress) The level of warpage of a silicon wafer having a diameter of 8 in. (20.32 cm) and a thickness of 1 mm was input in a laser internal stress measuring device FLX-2320, manufactured by KLA-Tencor Corporation. The composition was spin coated onto this silicon wafer to form a film which was then converted to a siliceous film by the method according to Examples or Comparative Examples. The temperature of the assembly was returned to room

temperature (23°C), followed by measurement of the internal stress with a laser internal stress measuring device FLX-2320, manufactured by KLA-Tencor Corporation. The film thickness was measured with Spectroscopic Ellipsometer (M-44, manufactured by J.A. Woollam), the same device as used in the evaluation of the specific permittivity.

(Crack limit film thickness) The composition solution was spin coated onto a silicon wafer having a diameter of 4 in. (10.16 cm) and a thickness of 0.5 mm to form a film which was then converted to a siliceous film by the method according to Examples or Comparative Examples. Samples having film thicknesses varied in the range of about 0.5 μm to about 5 μm were prepared by regulating the concentration of the solid matter in the composition solution or the rotating speed of the spin coater. Thin films after firing were observed under a microscope (x 120) for inspection of cracks to determine the crack-free maximum film thickness as the crack limit film thickness.

(Modulus of elasticity/nanoindentation method) The composition solution was spin coated on a silicon wafer having a diameter of 8 in. (20.32 cm) and a thickness of 1 mm to form a film which was then converted to a siliceous film by the method according to Examples or Comparative Examples. For the siliceous film thus obtained, the modulus of elasticity was measured by a mechanical property evaluation system for a thin film (Nano Indenter DCM, manufactured by MTS Systems Corporation, US) .

(Etching rate) The etching rate was determined by measuring the film thickness with Spectroscopic Ellipsometer (M-44), manufactured by J.A. Woollam and dividing the film thickness by chemical treatment time (min). The chemical used in the measurement of the etching rate is described in each Example which will be described later.

(Measurement of pore diameter) The composition solution was spin coated on a silicon wafer having a diameter of 8 in. (20.32 cm) and a thickness of 1 mm to form a film which was then converted to a siliceous film by the method according to Examples or Comparative Examples. The pore diameter of the film thus formed was measured by an X-ray diffuse scattering method using an XRD apparatus (ATX-G-type Advanced X-ray Diffractometer for surface structure evaluation, manufactured by Rigaku Corporation).

Reference Example 1 [Synthesis of polymethylsilazane (1)]

A stainless steel tank for raw material supply was mounted on a stainless steel tank reactor having an internal volume of 5 L. The air within the reactor was replaced by dry nitrogen. Thereafter, 780 g of methyltrichlorosilane was placed in the stainless steel tank for raw material supply and was pressure fed to and introduced into the reaction tank by nitrogen. Next, a raw material supply tank containing pyridine was connected to the reactor, and 4 kg of pyridine was pressure supplied by nitrogen in the same manner as described above. The pressure of the reactor was regulated to 1.0 kg/cm$^2$, and the temperature was regulated so that the temperature of the mixed solution within the reactor was brought to -4°C. Ammonia was blown into the mixed solution with stirring, and, when the pressure of the reactor reached 2.0 kg/cm$^2$, the supply of ammonia was stopped. An exhaust line was opened to lower the pressure of the reactor, and, subsequently, dry nitrogen was blown into the liquid layer for one hr to remove excess ammonia. The product thus obtained was filtered under pressure through a pressure filter in a dry nitrogen atmosphere to give 3200 mL of a filtrate. Pyridine was removed by evaporation by means of an evaporator to give about 340 g of polymethylsilazane. The number average molecular weight of the polymethylsilazane thus obtained was measured by GPC (developing liquid: $CHCl_3$) and was found to be 1800 in terms of polystyrene. In the IR (infrared absorption) spectrum of the polymethylsilazane, absorption attributable to N-H was observed at wavenumbers (cm$^{-1}$) 3350 and around 1200; absorption attributable to Si-C was observed at 2900 and 1250; and absorption attributable to Si-N-Si was observed at 1020 to 820. Reference Example 2 [Synthesis of polymethylsilazane (2)]

Polymethylsilazane (about 370 g) was synthesized in the same manner as in Reference Example 1, except that, instead of 780 g of methyltrichlorosilane, a mixture of 720 g of methyltrichlorosilane (about 4.8 mol) with 65 g of dimethyldichlorosilane (about 0.5 mol) (methyltrichlorosilane : dimethyldichlorosilane = 95 : 10 (mol/mol)) was used as the starting material. The number average molecular weight of the polymethylsilazane thus obtained was measured by GPC (developing liquid: $CHCl_3$) and was found to be 1400 in terms of polystyrene. In the IR (infrared absorption) spectrum of the polymethylsilazane, absorption attributable to N-H was observed at wavenumbers (cm$^{-1}$) 3350 and around 1200; absorption attributable to Si-C was observed at 2900 and 1250; and absorption attributable to Si-N-Si was observed at 1020 to 820.

Example 1:

A solution prepared by thoroughly dissolving 2 g of poly(n-butyl methacrylate (68 mol%) - methyl methacrylate (30 mol%) - methacrylic acid (2 mol%)) having a molecular weight of about 19,000 and 1 g of polyisobuyl acrylate having a molecular weight of 20,000 in 17 g of propylene glycol monomethyl ether acetate (hereinafter referred to as "PGMEA") was mixed in 80 g of a 15% PGMEA solution of polymethylsilazane synthesized in Reference Example 1 with thorough stirring. Subsequently, the solution was filtered through a PTFE Syringe Filter with a filtration accuracy of 0.2 μm, manufactured by Advantec Toyo Kaisha Ltd. The filtrate was spin coated onto a silicon wafer having a diameter of 10.2

cm (4 in.) and a thickness of 0.5 mm (2000 rpm, 20 sec), and the coating was dried at room temperature (5 min). Subsequently, the silicon wafer was heated in the atmosphere (25°C, relative humidity 40%) on a hot plate of 150°C and then 250°C each for 3 min. This film was allowed to stand in the atmosphere (25°C, relative humidity 40%) for 24 hr and was then fired in a dry nitrogen atmosphere at 400°C for 30 min. For the IR (infrared absorption) spectrum of the product, absorption attributable to Si-O at wavenumbers ($cm^{-1}$) 1100 and 450, absorption attributable to Si-C at wavenumbers ($cm^{-1}$) 1270 and 770, and absorption attributable to C-H at wavenumber ($cm^{-1}$) 2970 were mainly observed, while absorption attributable to N-H at wavenumbers ($cm^{-1}$) 3350 and 1200 and absorption attributable to (n-butyl methacrylate - methyl methacrylate - methacrylic acid) and polyisobutyl acrylate disappeared.

The film thus obtained was evaluated. As a result, the film had a specific permittivity of 2.21, a density of 1.0 $g/cm^3$, an internal stress of 30 MPa, and a crack limit film thickness of not less than 5 μm. Further, the film was allowed to stand in the atmosphere at a temperature of 23°C and a relative humidity of 50% for one week, and the specific permittivity was measured again. As a result, it was found that the specific permittivity remained unchanged. The modulus of elasticity of this film was measured by the nanoindentation method and was found to be 3.2 GPa. Further, the resistance (compatibility) of the siliceous film was examined using ACT-970 (manufactured by Ashland Chemical Company), ST-210, ST-250 (manufactured by ATMI), EKC265, and EKC640 (manufactured by EKC) which are extensively used as an etching residue peeling liquid. As a result, it was found that the etching rate was not more than 0.6 angstrom/min, and an increase in permittivity as determined by this test was not more than 1.0%.

The pore diameter of this film was measured by the X-ray diffuse scattering method. As a result, it was found that the average pore diameter was 20 angstroms.

Example 2:

A solution prepared by thoroughly dissolving 3 g of poly(iso-butyl methacrylate (71 mol%) - methyl methacrylate (28 mol%) - acrylic acid (1 mol%)) having a molecular weight of about 20,000 in 17 g of "PGMEA" was mixed in 80 g of a 15% PGMEA solution of polymethylsilazane synthesized in Reference Example 1 with thorough stirring. Subsequently, the solution was filtered through a PTFE Syringe Filter with a filtration accuracy of 0.2 μm, manufactured by Advantec Toyo Kaisha Ltd. The filtrate was spin coated onto a silicon wafer having a diameter of 10.2 cm (4 in.) and a thickness of 0.5 mm (2000 rpm, 20 sec), and the coating was dried at room temperature (5 min). Subsequently, the silicon wafer was heated in the atmosphere (25°C, relative humidity 40%) on a hot plate of 150°C and then 280°C each for 3 min. This film was allowed to stand in the atmosphere (25°C, relative humidity 40%) for 24 hr and was then fired in a dry nitrogen atmosphere at 400°C for 30 min. For the IR (infrared absorption) spectrum of the product, absorption attributable to Si-O at wavenumbers ($cm^{-1}$) 1020 and 450, absorption attributable to Si-C at wavenumbers ($cm^{-1}$) 1270 and 780, and absorption attributable to C-H at wavenumber ($cm^{-1}$) 2970 were mainly observed, while absorption attributable to N-H at wavenumbers ($cm^{-1}$) 3350 and 1200 and absorption attributable to poly(iso-butyl methacrylate - methyl methacrylate - acrylic acid) disappeared. The film thus obtained was evaluated. As a result, the film had a specific permittivity of 2.19 and a density of 1.0 $g/cm^3$, an internal stress of 32 MPa, and a crack limit film thickness of not less than 5 μm. Further, the film was allowed to stand in the atmosphere at a temperature of 23°C and a relative humidity of 50% for one week, and the specific permittivity was measured again. As a result, it was found that the specific permittivity remained unchanged. The modulus of elasticity of this film was measured by the nanoindentation method and was found to be 3.5 GPa. Further, the resistance (compatibility) of the siliceous film was examined using ACT-970 (manufactured by Ashland Chemical Company), ST-210, ST-250 (manufactured by ATMI), EKC265, and EKC640 (manufactured by EKC) which are extensively used as an etching residue peeling liquid. As a result, it was found that the etching rate was not more than 0.6 angstrom/min, and an increase in permittivity as determined by this test was not more than 1.1%.

The pore diameter of this film was measured by the X-ray diffuse scattering method. As a result, it was found that the average pore diameter was 18 angstroms.

Example 3

A solution prepared by thoroughly dissolving 8 g of poly(n-butyl methacrylate (80 mol%) - hydroxyethyl methacrylate (20 mol%)) having a molecular weight of about 100,000 in 32 g of PGMEA was mixed in 160 g of a 20% PGMEA solution of polymethylsilazane synthesized in Reference Example 2 with thorough stirring. Subsequently, the solution was filtered through a PTFE Syringe Filter with a filtration accuracy of 0.2 μm, manufactured by Advantec Toyo Kaisha Ltd. The filtrate was spin coated onto a silicon wafer having a diameter of 20.3 cm (8 in.) and a thickness of 1 mm (3500 rpm, 20 sec), and the coating was dried at room temperature (5 min). Subsequently, the silicon wafer was heated in the atmosphere (25°C, relative humidity 40%) on a hot plate of 150°C and then 250°C each for 3 min. This film was placed in a humidifier of temperature 70°C and relative humidity 85% for 3 min and was then fired in a dry nitrogen atmosphere at 400°C for 10 min. For the IR (infrared absorption) spectrum of the product, absorption attributable to Si-O at wavenumbers ($cm^{-1}$) 1020 and 440, absorption attributable to Si-C at wavenumbers ($cm^{-1}$) 1290 and 770, and absorption

attributable to C-H at wavenumber ($cm^{-1}$) 2980 were mainly observed, while absorption attributable to N-H at wavenumbers ($cm^{-1}$) 3350 and 1200 and absorption attributable to poly(n-butyl methacrylate - hydroxyethyl methacrylate) disappeared. The film thus obtained was evaluated. As a result, the film had a specific permittivity of 2.04 and a density of 0.9 g/$cm^3$, an internal stress of 25 MPa, and a crack limit film thickness of not less than 5 μm. Further, the film was allowed to stand in the atmosphere at a temperature of 23°C and a relative humidity of 50% for one week, and the specific permittivity was measured again. As a result, it was found that the specific permittivity remained unchanged. The modulus of elasticity of this film was measured by the nanoindentation method and was found to be 3.1 GPa. Further, a compatibility test of the siliceous film was carried out using ACT-970 (manufactured by Ashland Chemical Company), ST-210, and ST-250 (manufactured by ATMI) which are extensively used as an etching residue peeling liquid. As a result, it was found that the etching rate was not more than 0.7 angstrom/min, and an increase in permittivity as determined by this test was not more than 1.5%. The pore diameter of this film was measured by the X-ray diffuse scattering method. As a result, it was found that the average pore diameter was 21 angstroms.

Comparative Example 1

A solution prepared by thoroughly dissolving 3 g of poly-n-butyl methacrylate having a molecular weight of about 160,000 in 17 g of dibutyl ether was mixed in 80 g of a 15% dibutyl ether solution of polymethylsilazane synthesized in Reference Example 1 with thorough stirring. Subsequently, the solution was filtered through a PTFE Syringe Filter with a filtration accuracy of 0.2 μm, manufactured by Advantec Toyo Kaisha Ltd. The filtrate was spin coated onto a silicon wafer having a diameter of 10.2 cm (4 in.) and a thickness of 0.5 mm (2000 rpm, 20 sec), and the coating was dried at room temperature (5 min). Subsequently, the silicon wafer was heated in the atmosphere (25°C, relative humidity 40%) on a hot plate of 150°C and then 250°C each for 3 min. This film was allowed to stand in the atmosphere (25°C, relative humidity 40%) for 24 hr and was then fired in a dry nitrogen atmosphere at 400°C for 30 min. For the IR (infrared absorption) spectrum of the product, absorption attributable to Si-O at wavenumbers ($cm^{-1}$) 1030 and 450, absorption attributable to Si-C at wavenumbers ($cm^{-1}$) 1270 and 780, and absorption attributable to C-H at wavenumber ($cm^{-1}$) 2970 were mainly observed, while absorption attributable to N-H at wavenumbers ($cm^{-1}$) 3350 and 1200 and absorption attributable to polyisobutyl methacrylate disappeared. The film thus obtained was evaluated. As a result, the film had a specific permittivity of 2.31 and a density of 1.1 g/$cm^3$, and an internal stress of 35 MPa. However, as a result of the measurement of the pore diameter of this film by the X-ray diffuse scattering method, the average pore diameter was as large as 70 angstroms. Further, the modulus of elasticity was measured by the nanoindentation method and was found to be 2.6 GPa.

From the above Examples, it is apparent that, when an organic resin component containing group -COOH and/or group -OH is contained, the size of pores of the formed film is smaller than that of films formed using the conventional coating composition, and, thus, a film having improved mechanical strength can be realized.

INDUSTRIAL APPLICABILITY

The porous siliceous film provided by the present invention stably exhibits a very low level of specific permittivity and, in addition, has mechanical strength and adhesion high enough to withstand advanced high integration processes including CMP and has resistance to various chemicals. Therefore, the porous siliceous film provided by the present invention is particularly useful as an interlayer insulation film for semiconductor devices that is suitable for advanced high integration processes including a damascene process.

## Claims

**1.** A coating composition **characterized by** comprising:

an organic solvent and, contained in said organic solvent,

1) a polyalkylsilazane and
2) at least one organic resin component selected from the group consisting of homopolymers and copolymers of acrylic esters and methacrylic esters,

group -COOH and/or group -OH being contained in at least a part of side groups contained in at least one type of the organic resin component, **characterized in that** said group -COOH and/or group -OH are contained in an amount of 0.01 to 50% by mole based on the total number of monomers of said organic resin component.

**2.** The coating composition according to claim 1, **characterized in that** said organic resin component has a number average molecular weight of 1,000 to 800,000.

**3.** The coating composition according to claim 1 or 2, **characterized in that** said organic resin component is contained in an amount of 5 to 150% by mass based on said polyalkylsilazane.

**4.** The coating composition according to any one of claims 1 to 3, **characterized in that** said polyalkylsilazane comprises repeating units represented by formula (1) and at least one type of units represented by formula (2) or formula (3) and has a number average molecular weight of 100 to 50,000:

$$-(SiR^1(NR^2)_{1.5})- \qquad (1)$$

wherein $R^1$ and $R^2$ each independently represent a hydrogen atom or an alkyl group having 1 to 3 carbon atoms, excluding the case where $R^1$ and $R^2$ simultaneously represent a hydrogen atom;

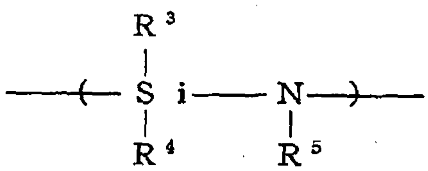

(2)

wherein $R^3$, $R^4$ and $R^5$ each independently represent a hydrogen atom or an alkyl group having 1 to 3 carbon atoms, excluding the case where $R^3$ and $R^4$ simultaneously represent a hydrogen atom;

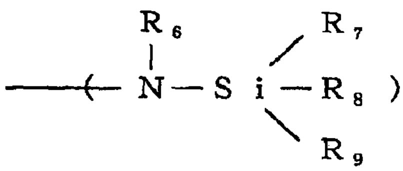

(3)

wherein $R^6$ to $R^9$ each independently represent a hydrogen atom or an alkyl group having 1 to 3 carbon atoms, excluding the case where all of $R^6$, $R^7$, and $R^8$ represent a hydrogen atom.

**5.** The coating composition according to claim 4, **characterized in that**, in formula (1), $R^1$ represents a methyl group and $R^2$ represents a hydrogen atom; in formula (2), $R^3$ and $R^4$ represent a hydrogen atom or a methyl group and $R^5$ represents a hydrogen atom; and, in formula (3), $R^7$, $R^8$ and $R^9$ represent a methyl group and $R^6$ represents a hydrogen atom.

**6.** The coating composition according to claim 4 or 5, **characterized in that** said polyalkylsilazane comprises not less than 50%, based on the total number of units represented by formulae (1), (2) and (3), of repeating units represented by formula (1).

**7.** The coating composition according to claim 6, **characterized in that** said polyalkylsilazane comprises not less than 80%, based on the total number of units represented by formulae (1), (2) and (3), of repeating units represented by formula (1).

**8.** A porous siliceous film **characterized by** being produced by firing a film of a coating composition according to any one of claims 1 to 7, said porous siliceous film having a specific permittivity of less than 2.5, and a modulus of elasticity of not less than 3 GPa.

**9.** A process for producing a porous siliceous film **characterized by** comprising coating a coating composition onto a substrate according to any one of claims 1 to 7 to form a film which is prefired in a water vapor-containing atmosphere at a temperature of 50 to 300°C and is then fired in a dry atmosphere at a temperature of 300 to 500°C.

**10.** The process for producing a porous siliceous film according to claim 9, **characterized in that** the prefired film is allowed to stand in the atmosphere or is subjected to moisture absorption under a humidified atmosphere followed by firing.

**11.** A semiconductor device **characterized by** comprising a porous siliceous film according to claim 8 as an interlayer insulation film.

**12.** The use of a coating composition according to any one of claims 1 to 7 for providing a porous siliceous film.

**13.** The use of a porous siliceous film according to claim 8 as an interlayer insulation film for semiconductor devices.

**Patentansprüche**

**1.** Beschichtungszusammensetzung, enthaltend:

ein organisches Lösungsmittel und, in dem organischem Lösungsmittel enthalten,

1) ein Polyalkylsilazan und
2) mindestens eine organische Harzkomponente ausgewählt aus der Gruppe bestehend aus Homopolymeren und Copolymeren von Acrylestern und Methacrylestern,

wobei eine Gruppe -COOH und/oder eine Gruppe -OH in mindestens einem Teil der Seitengruppen, die in mindestens einem Teil der organischen Harzkomponente enthalten sind, enthalten sind,
**dadurch gekennzeichnet, dass** die Gruppe -COOH und/oder die Gruppe -OH in einer Menge von 0,01 bis 50 mol-%, bezogen auf die Gesamtzahl der Monomere der organischen Harzkomponente, enthalten sind.

**2.** Beschichtungszusammensetzung gemäß Anspruch 1, **dadurch gekennzeichnet, dass** die organische Harzkomponente ein zahlenmittleres Molekulargewicht von 1000 bis 800000 aufweist.

**3.** Beschichtungszusammensetzung gemäß Anspruch 1 oder 2, **dadurch gekennzeichnet, dass** die organische Harzkomponente in einer Menge von 5 bis 150 Gew.-%, bezogen auf das Polyalkylsilazan, enthalten ist.

**4.** Beschichtungszusammensetzung gemäß einem der Ansprüche 1 bis 3, **dadurch gekennzeichnet, dass** das Polyalkylsilazan Repetiereinheiten der Formel (I) und mindestens einen Typ von Einheiten der Formel (II) oder Formel (III) enthält und ein zahlenmittleres Molekulargewicht von 100 bis 50000 aufweist:

$-(SiR^1(NR^2)_{1,5})-$ (1)

wobei $R^1$ und $R^2$ jeweils unabhängig ein Wasserstoffatom oder eine Alkylgruppe mit 1 bis 3 Kohlenstoffatomen darstellen, wobei der Fall, in dem $R^1$ und $R^2$ gleichzeitig ein Wasserstoffatom darstellen, ausgenommen ist;

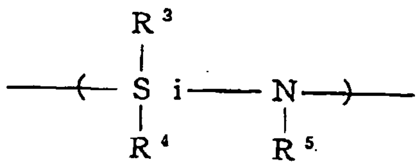
(2)

wobei $R^3$, $R^4$ und $R^5$ jeweils unabhängig ein Wasserstoffatom oder eine Alkylgruppe mit 1 bis 3 Kohlenstoffatomen darstellen, wobei der Fall, in dem $R^3$ und $R^4$ gleichzeitig ein Wasserstoffatom darstellen, ausgenommen ist;

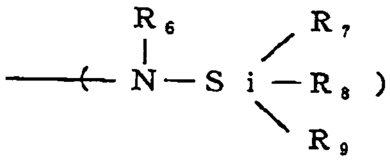 (3)

wobei $R^6$ bis $R^9$ jeweils unabhängig ein Wasserstoffatom oder eine Alkylgruppe mit 1 bis 3 Kohlenstoffatomen darstellen, wobei der Fall, in dem $R^6$, $R^7$ und $R^8$ alle ein Wasserstoffatom darstellen, ausgenommen ist.

5. Beschichtungszusammensetzung gemäß Anspruch 4, **dadurch gekennzeichnet, dass** in Formel (1) $R^1$ eine Methylgruppe darstellt und $R^2$ ein Wasserstoffatom darstellt; in Formel (2) $R^3$ und $R^4$ ein Wasserstoffatom oder eine Methylgruppe darstellen und $R^5$ ein Wasserstoffatom darstellt; und in Formel (3) $R^7$, $R^8$ und $R^9$ eine Methylgruppe darstellen und $R^6$ ein Wasserstoffatom darstellt.

6. Beschichtungszusammensetzung gemäß Anspruch 4 oder 5, **dadurch gekennzeichnet, dass** das Polyalkylsilazan nicht weniger als 50 %, bezogen auf die Gesamtzahl an Einheiten der Formeln (1), (2) und (3), an Repetiereinheiten der Formel (1) enthält.

7. Beschichtungszusammensetzung gemäß Anspruch 6, **dadurch gekennzeichnet, dass** das Polyalkylsilazan nicht weniger als 80%, bezogen auf die Gesamtzahl an Einheiten der Formeln (1), (2) und (3), an Repetiereinheiten der Formel (1) enthält.

8. Poröser siliziumdioxidhaltiger Film, hergestellt durch Erhitzen eines Films einer Beschichtungszusammensetzung gemäß einem der Ansprüche 1 bis 7, wobei der poröse siliziumdioxidhaltige Film eine spezifische Permittivität von weniger als 2,5 und ein Elastizitätsmodul von nicht weniger als 3 GPa aufweist.

9. Verfahren zur Herstellung eines porösen siliziumdioxidhaltigen Films, umfassend Aufbringen einer Beschichtungszusammensetzung auf ein Substrat gemäß einem der Ansprüche 1 bis 7, um einen Film auszubilden, der in einer Wasserdampf enthaltenden Atmosphäre bei einer Temperatur von 50 bis 300°C vorerhitzt wird und dann in einer trockenen Atmosphäre bei einer Temperatur von 300 bis 500°C erhitzt wird.

10. Verfahren zur Herstellung eines porösen siliziumdioxidhaltigen Films gemäß Anspruch 9, **dadurch gekennzeichnet, dass** der vorerhitzte Film in der Atmosphäre stehen gelassen wird oder einer Feuchtigkeitsabsorption in einer angefeuchteten Atmosphäre unterzogen wird, gefolgt von Erhitzen.

11. Halbleitervorrichtung, umfassend einen porösen siliziumdioxidhaltigen Film gemäß Anspruch 8 als Zwischenschichtsisolationsfilm.

12. Verwendung einer Beschichtungszusammensetzung gemäß einem der Ansprüche 1 bis 7 zur Bereitstellung eines porösen siliziumdioxidhaltigen Films.

13. Verwendung eines porösen siliziumdioxidhaltigen Films gemäß Anspruch 8 als Zwischenschichtsisolationsfilm für Halbleitervorrichtungen.

## Revendications

1. Composition de revêtement **caractérisée en ce qu'**elle comprend :

un solvant organique et, contenus dans ledit solvant organique,

1) un polyalkylsilazane et
2) au moins un composant de résine organique choisi dans le groupe constitué par les homopolymères et copolymères d'esters acryliques et d'esters méthacryliques,

le groupe -COOH et/ou le groupe -OH étant contenus dans au moins une partie des groupes latéraux contenus

dans au moins un type du composant de résine organique, **caractérisée en ce que** ledit groupe -COOH et/ou ledit groupe -OH sont contenus dans une quantité de 0,01 à 50 % en moles, rapporté au nombre total de monomères dudit composant de résine organique.

2. Composition de revêtement selon la revendication 1, **caractérisée en ce que** ledit composant de résine organique a un poids moléculaire moyen en nombre de 1000 à 800 000.

3. Composition de revêtement selon la revendication 1 ou 2, **caractérisée en ce que** ledit composant de résine organique est contenu dans une quantité de 5 à 150 % en masse, rapporté audit polyalkylsilazane.

4. Composition de revêtement selon l'une quelconque des revendications 1 à 3, **caractérisée en ce que** ledit polyalkylsilazane comprend des motifs répétitifs représentés par la formule (1) et au moins un type de motifs représentés par la formule (2) ou la formule (3) et a un poids moléculaire moyen en nombre de 100 à 50 000 :

$$-(SiR^1(NR^2)_{1,5})- \qquad (1)$$

dans laquelle $R^1$ et $R^2$ représentent chacun indépendamment un atome d'hydrogène ou un groupe alkyle portant 1 à 3 atomes de carbone, à l'exclusion du cas où $R^1$ et $R^2$ représentent simultanément un atome d'hydrogène ;

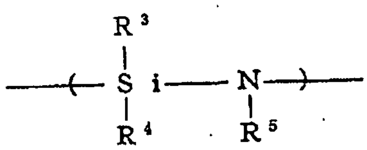

(2)

dans laquelle $R^3$, $R^4$ et $R^5$ représentent chacun indépendamment un atome d'hydrogène ou un groupe alkyle portant 1 à 3 atomes de carbone, à l'exclusion du cas où $R^3$ et $R^4$ représentent simultanément un atome d'hydrogène ;

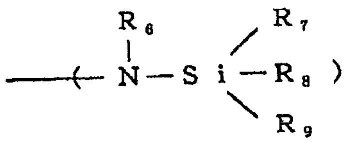

(3)

dans laquelle $R^6$ à $R^9$ représentent chacun indépendamment un atome d'hydrogène ou un groupe alkyle portant 1 à 3 atomes de carbone, à l'exclusion du cas où $R^6$, $R^7$ et $R^8$ représentent tous un atome d'hydrogène.

5. Composition de revêtement selon la revendication 4, **caractérisée en ce que**, dans la formule (1), $R^1$ représente un groupe méthyle et $R^2$ représente un atome d'hydrogène ; dans la formule (2), $R^3$ et $R^4$ représentent un atome d'hydrogène ou un groupe méthyle et $R^5$ représente un atome d'hydrogène ; et dans la formule (3), $R^7$, $R^8$ et $R^9$ représentent un groupe méthyle et $R^6$ représente un atome d'hydrogène.

6. Composition de revêtement selon la revendication 4 ou 5, **caractérisée en ce que** ledit polyalkylsilazane comprend au moins 50 %, rapporté au nombre total de motifs représentés par les formules (1), (2) et (3), de motifs répétitifs représentés par la formule (1).

7. Composition de revêtement selon la revendication 6, **caractérisée en ce que** ledit polyalkylsilazane comprend au moins 80 %, rapporté au nombre total de motifs représentés par les formules (1), (2) et (3), de motifs répétitifs représentés par la formule (1).

8. Film siliceux poreux **caractérisé en ce qu'**il est produit par cuisson d'un film d'une composition de revêtement selon l'une quelconque des revendications 1 à 7, ledit film siliceux poreux ayant une permittivité spécifique inférieure à 2,5, et un module d'élasticité supérieur ou égal à 3 GPa.

9. Procédé de production d'un film siliceux poreux **caractérisé en ce qu'**il comprend le dépôt sur un substrat d'une composition de revêtement selon l'une quelconque des revendications 1 à 7 pour former un film qui est précuit dans

une atmosphère contenant de la vapeur d'eau à une température de 50 à 300 °C et est ensuite cuit dans une atmosphère sèche à une température de 300 à 500 °C.

**10.** Procédé de production d'un film siliceux poreux selon la revendication 9, **caractérisé en ce que** le film précuit est laissé au repos dans l'atmosphère ou est soumis à une absorption d'humidité sous une atmosphère humidifiée suivie de la cuisson.

**11.** Dispositif semi-conducteur **caractérisé en ce qu'**il comprend un film siliceux poreux selon la revendication 8 comme film d'isolation intercalaire.

**12.** Utilisation d'une composition de revêtement selon l'une quelconque des revendications 1 à 7 pour l'obtention d'un film siliceux poreux.

**13.** Utilisation d'un film siliceux poreux selon la revendication 8 comme film d'isolation intercalaire pour dispositifs semi-conducteurs.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002075982 A
- JP 7292321 A
- JP 7305029 A
- WO 0219410 A